(19) Europäisches Patentamt
European Patent Office
Office européen des brevets

(11) Publication number: **0 505 903 A1**

## (12) EUROPEAN PATENT APPLICATION

(21) Application number: **92104646.2**

(51) Int. Cl.5: **G03F 7/105**

(22) Date of filing: **18.03.92**

(30) Priority: **28.03.91 IT MI910844**

(43) Date of publication of application:
**30.09.92 Bulletin 92/40**

(84) Designated Contracting States:
**AT BE CH DE DK ES FR GB GR IT LI LU MC NL PT SE**

(71) Applicant: **PLURIMETAL S.R.L.**
**Via Salieri, 4**
**I-37050 Vallese di Oppeano (Verona)(IT)**

(72) Inventor: **Rinaldi, Rinaldo**
**Via Salieri, 4**
**I-37050 Vallese di Oppeano, (Verona)(IT)**

(74) Representative: **Minoja, Fabrizio**
**Studio Consulenza Brevettuale Via Rossini, 8**
**I-20122 Milano(IT)**

# (54) A photosensitive composition for offset lithography plates.

(57) A photosensitive composition for offset lithography plates containing a first photoreactive compound, one or more resins and/or plasticizers, one or more dyes and a second photoreactive compound, capable of accentuating the image of the master after exposition to UV light, characterized in that said second photoreactive compound is a triazine derivative of formula (III)

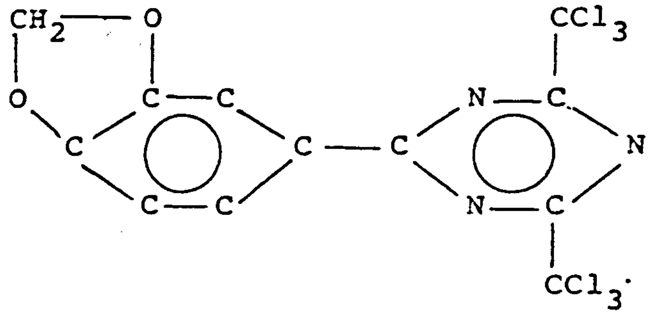

(III)

EP 0 505 903 A1

The present invention relates to a photosensitive composition for offset lithography plates. More particularly, the present invention relates to a photosensitive composition containing orto-naphthoquinone diazide derivatives, as the photoreactive compound, one or more resins and/or plasticizers, one or more dyes capable of forming salts and a second photoreactive compound, capable of accentuating the image of the master after exposition to UV light.

Triazine derivatives have already been used as photodeveloper agents in photosensitive compositions for offset lithography plates.

For example, GB 1,591,113 discloses a photosensitive composition containing a triazine, capable of releasing an acid by photodecomposition, of general formula

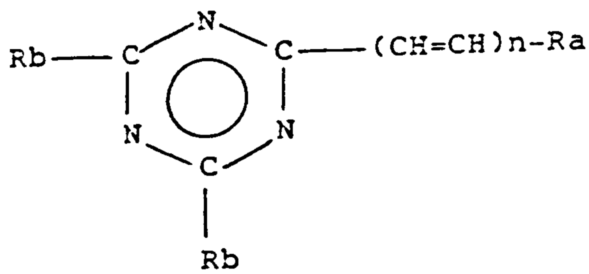

(I)

wherein Ra is a substituted or unsubstituted aryl or heterocyclic aromatic group;
Rb is a trihalogen substituted alkyl or alkenyl group having from 1 to 3 carbon atoms and n is an integer from 1 to 3.

Similar compositions were also described in DE 3801065 and JP-A-8560104.

Structurally similar triazine derivatives were also described for different purposes, for example as polymerization photoinitiators for the preparation of adhesive tapes.

For example WO 81/02262 discloses compounds of formula (II)

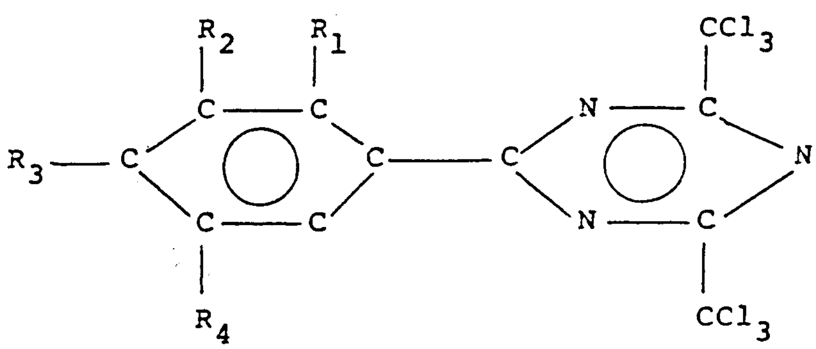

(II)

wherein $R_1$, $R_2$ $R_3$ and $R_4$ are independently hydrogen, alkyl (preferably methyl or ethyl), alkoxy (preferably methoxy or ethoxy), with the proviso that from 1 to 3 groups $R_1$, $R_2$, $R_3$ and $R_4$ are hydrogen atoms. Preferably, the alkyl and alkoxy groups have no more than 12 carbon atoms (US 3,954,475) and at most two of them can have more than 6 carbon atoms contemporaneously. Alkoxy groups are preferred since they raise the maximun absorption wavelenght towards less energetic radiations, thus allowing higher reaction rates. Particularly, adjacent alkoxy groups preferably form a ring, such as for example in the compounds of formula (III)

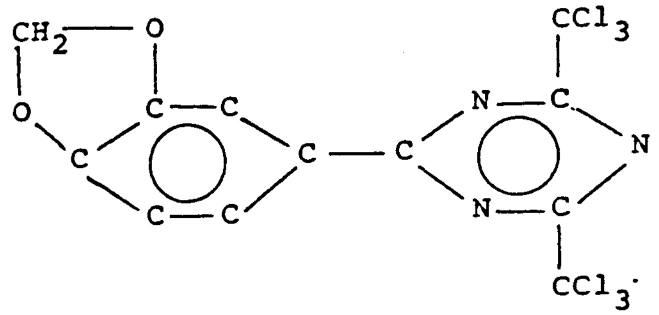

(III)

All the above cited triazine derivatives can be conveniently prepared by nitrile co-trimerization, according to the method disclosed in Bull. Chem. Soc. Japan vol. 42, page 2924 (1969).

It has now been found that the compound of formula (III) can advantageously be used in photosensitive composition for offset lithography plates as photodeveloper agent.

In comparison with the well-known compositions, the present invention allows to obtain unexpected advantages as to the contrast of the image developed on the plate.

Therefore, the object of the present invention is a photosensitive composition for offset lithography plates characterized in that it contains the triazine of formula (III).

The photosensitive composition can consist of an orto-naphthoquinone diazide sulfonic or carboxylic acid ester or amide and, on the ground of this amount, from 0.01 to 50% by weight of organic dyes capable of forming salts and from 0.01 to 50% by weight of the triazine derivative of formula (III).

A preferred embodiment of the invention provides a composition containing from 0.01 to 10% by weight of organic dyes and from 0.01 to 5% by weight of the photosensitive derivative (III), with reference to the weight amount of the o-quinone diazide derivative.

Preferred dyes are of basic type, belonging to triarylmethane group, such as for example triphenylmethane derivatives, wherein the phenyl groups are substituted with $NH_2$, OH, $SO_3H$ groups, or other groups such as azines, phenazines, oxazines. Derivatives of anthraquinone group are also provided. Examples of these dyes are Crystal Violet (C.I. 42555), Sudan Blue (C.I. 61520), Malachite Green (C.I. 42000), Victoria Blue (C.I. 44045), Nile Blue BX (C.I. 51185), Brilliant Green (C.I. 42040), etc.

Optimal results in colour change and contrast are obtained with appropriate mixtures of the above dyes.

The photosensitive composition can further contain two or more o-quinone diazide derivatives, in which case the percent amount of the other components is referred to the total weight of said derivatives. Also resins and/or plasticizers can be used. Preferably, Novolac resins are used.

The supports for the photosensitive layer are those commonly used in the prior art; metal plates, such as aluminium or zinc plate, having appropriately pretreated surfaces; multimetal plates, such as chromium-copper-aluminium plate; plastic films.

Accordingly, variously coloured positive layers, having very good colour change after exposition, which is visible even under yellow light and with very good image contrast from the background after development, are obtained.

The derivative (III) satisfies all the requirements necessary for use in a photosensitive composition:

- melting point is 134 ° C;
- extinction coefficient is 17.7E-3;
- very good solubility in usual solvents;
- very good shelf-life of the obtained plates.

The present invention is further illustrated by means of the following examples.

## EXAMPLE 1

Photosensitive composition prepared according to the following formulation:

- 2.50 parts by weight of the product obtained from the esterification reaction between 1,2-naphthoquinone diazide 5-sulfonic acid and a cresol-formaldehyde resin;
- 2.50 parts by weight of the product obtained from the esterification reaction between 1,2-naphthoquinone diazide 5-sulfonic acid and a phenol-formaldehyde resin;
- 0.40 parts by weight of the derivative (III);
- 0.057 parts by weight of Crystal Violet;

were dissolved in a mixture consisting of:

- 1.5 parts by weight of dimethylformamide;
- 60 parts by weight of butylcellosolve.

The obtained composition was then spreaded on a mechanically grained and anodized aluminium sheet, obtaining a blue coloured plate, which, after exposure to UV radiation through a positive film, gave an image which was sharply visible also in yellow light, without intensity decrease in time. Even also developing with an alkaline solution an image with very good contrast from background was obtained.

The exposition to radiation was carried out with a 5000 Watt halogen source, at a distance of 1200 cm, for 45 seconds.

## EXAMPLE 2

Photosensitive composition prepared according to the following formulation:

- 3.50 parts by weight of the product obtained from the esterification reaction between 1,2-naphthoquinone diazide 5-sulfonic acid and a phenol-formaldehyde resin;
- 1.50 parts by weight of the product obtained from the esterification reaction between 1,2-naphthoquinone diazide 5-sulfonic acid and a cresol-formaldehyde resin;
- 0.045 parts by weight of the derivative (III);
- 0.040 parts by weight of Crystal Violet;
- 0.040 parts by weight of Sudan Blue;

were dissolved in a mixture consisting of:

- 15 parts by weight of dimethylformamide;
- 60 parts by weight of carbitol.

The obtained composition was spinned on a mechanically grained and anodized aluminium sheet, obtaining a light blue coloured plate, which after exposure to UV radiation through a positive film, revealed a very good image visibility.

## EXAMPLE 3

Photosensitive composition prepared according to the following formulation:

- 4.0 parts by weight of the product obtained from the esterification reaction between 1,2-naphthoquinone diazide 5-sulfonic acid and a phenol-formaldehyde resin;
- 1.0 parts by weight of Bakelite 6564®;
- 0.040 parts by weight of the derivative (III);
- 0.055 parts by weight of Crystal Violet;

were dissolved in a mixture consisting of:

- 15 parts by weight of dimethylformamide;
- 60 parts by weight of butylcellosolve.

The obtained composition was then spreaded on a mechanically grained and anodized aluminium sheet, obtaining a blue coloured offset plate, which after exposure to UV radiation through a positive film, gave a very good contrast of exposed parts.

## Claims

1. A photosensitive composition for offset lithography plates containing a first photoreactive compound, one or more resins and/or plasticizers, one or more dyes and a second photoreactive compound, capable of accentuating the image of the master after exposition to UV light, characterized in that said second photoreactive compound is a triazine derivative of formula (III)

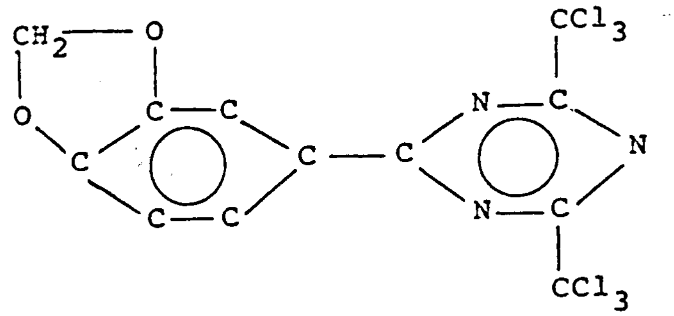

(III)

2. A photosensitive composition according to claim 1 wherein the triazine (III) is contained in an amount ranging from 0.01 to 5% by weight.

3. A photosensitive composition according to claims 1 and 2 consisting of one or more basic dyes, deriving from triphenylmethane or anthraquinone, in an amount ranging from 0.01 to 50% by weight based on the total solid mass.

4. A photosensitive composition according to claim 3 consisting of one or more basic dyes, deriving from triphenylmethane or anthraquinone, in an amount ranging from 0.01 to 10% by weight based on the total solid mass.

5. A photosensitive composition according to claims 1-4, wherein the main component consists of one or more derivatives of esters of 1,2-naphthoquinone diazide 5-sulfonic acid with phenol-formaldehyde and/or cresolformaldehyde resin, in an amount ranging from 1 to 99.7% by weight, based on the total of the solid.

6. A photosensitive composition according to claims 1-5 containing a novolac-type resin, in an amount ranging from 1 to 50% by weight, based on the total of the solid.

7. A photosensitive composition according to claims 1-6 using a grained or grained and anodized aluminium plate as support, which is used for the manufacturing of offset lithography plates.

European Patent Office

# EUROPEAN SEARCH REPORT

Application Number

EP 92 10 4646

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 078 980 (HOECHST AG) * the whole document * | 1-7 | G03F7/105 |
| Y | DE-A-3 601 264 (FUJI PHOTO FILM) * page 32, line 1 - line 8; claim 1 * | 1-7 | |
| Y | EP-A-0 137 452 (HOECHST AG) * the whole document * | 1-7 | |

TECHNICAL FIELDS SEARCHED (Int. Cl.5 )

G03F

The present search report has been drawn up for all claims

| Place of search | Date of completion of the search | Examiner |
|---|---|---|
| THE HAGUE | 03 JULY 1992 | HAENISCH U.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document